# FASCICULE DE BREVET EUROPEEN

(11) **EP 0 593 366 B1**
(45) Date de publication et mention de la délivrance du brevet: **06.09.2000**
(21) Numéro de dépôt: 93402533.9
(22) Date de dépôt: 14.10.1993
(51) Int. Cl.: H01L 21/00

(54) **Boîte plate de confinement d'un objet plat sous atmosphère spéciale**
Flache Verschlussdose für einen flachen Gegenstand in einer spezialen Atmosphäre
Flat confinement housing for a flat object in a special atmosphere

(30) Priorité: 16.10.1992 FR 9212423
(43) Date de publication de la demande: 20.04.1994
(73) Titulaire: COMMISSARIAT A L'ENERGIE ATOMIQUE, 75015 Paris (FR)
(72) Inventeur: Doche, Claude, F-38640 Claix (FR)
(74) Mandataire: Dubois-Chabert, Guy

(56) Documents cités:
- EP-A- 0 246 587
- EP-A- 0 273 791
- WO-A-92/02950

## Description

### DOMAINE DE L'INVENTION

L'invention concerne le stockage et le transport d'objets plats sous atmosphère spéciale, en particulier dans le cadre de leur fabrication ou de leur traitement. L'ivention s'applique particulièrement à des tranches de silicium confinées sous atmosphère ultrapropre. Ces tranches ou plaques de silicium sont utilisées pour la fabrication des circuits intégrés dans le domaine de l'électronique et de la micro-électronique. Néanmoins, l'invention peut s'appliquer à n'importe quel objet plat à stocker individuellement dans une boîte plate.

### ART ANTERIEUR ET PROBLEME POSE

Dans le cadre de la fabrication des circuits électroniques sur des tranches ou plaques circulaires de silicium, les différentes opérations sont effectuées dans des postes de travail sous atmosphère ultrapropre. Dans ces conditions, le volume interne de ces postes de travail doit être soumis constamment à l'atmosphère ultrapropre. Il en est de même pour les volumes à l'intérieur desquels évoluent les objets entre les postes de travail.

On connaît ainsi des locaux, appelés "salles blanches", dont toute l'atmosphère est maintenue à un degré très élevé de propreté. Il est également connu de confiner les objets plats durant leur transport entre deux postes de travail dans des conteneurs spéciaux ou des tunnels dont les volumes internes sont constamment soumis à une ventilation de l'atmosphère ultrapropre en question.

On conçoit facilement que ces installations permettant de confiner ces objets plats entre deux postes de travail sous atmosphère ultrapropre soient conséquentes, sophistiquées, et donc onéreuses. Il en est de même à un degré supérieur, en ce qui concerne les installations des "salles blanches".

Le but de l'invention est de remédier à ces inconvénients en évitant l'usage de ces installations de confinement sous atmosphère ultrapropre des objets plats durant leur stockage et leur transport entre plusieurs postes de travail.

De plus, dans le document de brevet EP-A-0 273 791, dont le titulaire est le présent demandeur, on décrit l'organisation du stockage et du transfert de tranches de silicium d'une armoire à une autre, au moyen d'un conteneur portable ventilé. Une ventilation est organisée à l'intérieur du conteneur, le flux d'air propre balayant longitudinalement l'ensemble des tranches.

Or, par le document de brevet WO-A-92 02950, on connaît l'utilisation de cassettes pour stocker des plaques de silicium. Chaque cassette est placée dans une structure de rangement, elle-même placée à l'extérieur d'une chambre propre ou une salle blanche. Chaque cassette est équipée d'une porte placée sur un de ses côtés, et permettant ainsi d'obturer l'orifice d'accès de la cassette.

### RESUME DE L'INVENTION

Le déposant propose de suivre ce concept consistant à réduire au minimum le volume d'atmosphère ultrapropre entourant chaque objet, en utilisant une boite plate de confinement d'un objet plat sous atmosphère spéciale.

Selon l'invention, la boite comprend les caractéristiques citées dans la revendication 1.

La réalisation préférentielle de l'invention prévoit que la section interne de la boîte est une ellipse horizontale, et que les moyens internes latéraux de maintien de l'objet sont constitués par les sommets du grand axe de l'ellipse.

En fonction des différents systèmes de traitement des objets plats, la boîte comporte un système d'ancrage sur le bloc aéraulique, pour permettre la fixation de la boîte à un organe de manutention du système de traitement.

Dans le cadre de la gestion informatique du traitement des objets contenus dans les boîtes, il est avantageux que chaque boîte possède une carte informatique sur son bloc aéraulique, cette carte pouvant être activée pour lire et écrire des informations véhiculées par la boîte et relatives à l'objet qu'elle contient.

De préférence, la boîte comporte un système de fermeture et d'ouverture de la porte. Ce système peut être un système de blocage du type capsulage à levier, dont une barre horizontale de manoeuvre dépasse du corps de la boîte pour permettre l'actionnement du système de fermeture et d'ouverture.

La réalisation préférentielle de la boîte prévoit que les ouvertures se trouvent chacune sur la totalité de leur face latérale et que le bloc aéraulique possède un diffuseur placé sur toute la longueur de la deuxième ouverture pour diffuser par un écoulement quasiment laminaire à l'intérieur de la boîte un gaz constituant l'atmosphère spéciale.

Le diffuseur peut être une paroi perforée de façon régulière, telle qu'une grille. La forme du diffuseur est choisie pour assurer un blocage arrière de l'objet.

Dans une autre réalisation, le diffuseur peut être réalisé par une enveloppe filtrante, amovible, interchangeable et semi-rigide entourant l'objet, permettant de diffuser l'atmosphère spéciale autour de l'objet et possédant une ouverture latérale pour l'introduction de l'objet.

Cette enveloppe filtrante est de préférence élastique et fixée à la porte pour assurer le blocage de l'objet contre la face interne de la porte et l'accès à l'objet par un doigt terminal d'un robot du type "pick and place".

### LISTE DES FIGURES

L'invention et ses caractéristiques seront mieux comprises à la lecture de la description suivante, qui est accompagnée de quatre figures représentant respectivement :
- figure 1, la boîte selon l'invention, positionnée dans un râtelier de stockage ;
- figure 2, en coupe, le mécanisme d'ouverture et de fermeture de la porte de la boîte selon l'invention ;
- figure 3, en coupe, une première réalisation de l'intérieur de la boîte selon l'invention ; et
- figure 4, en coupe, une deuxième réalisation de l'intérieur de la boîte selon l'invention.

### DESCRIPTION DETAILLEE D'UNE REALISATION DE L'INVENTION

La présente réalisation concerne, par exemple, une application à la fabrication des circuits intégrés sur des tranches ou plaques de silicium, mais pourrait concerner la fabrication d'écrans plats.

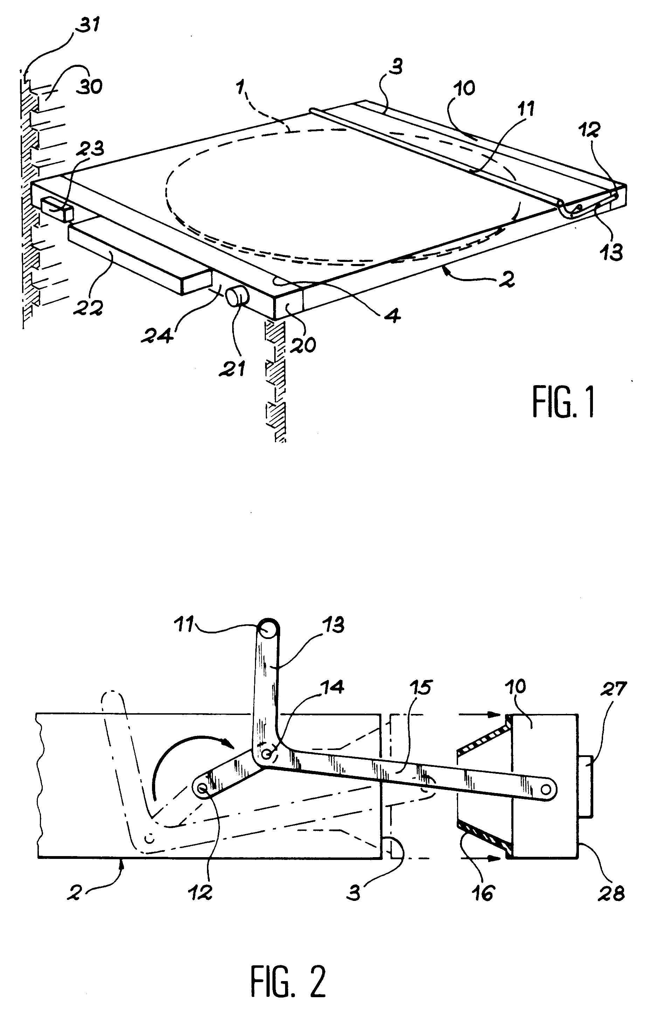

En référence à la figure 1, la boîte selon l'invention a une forme plate, carrée ou rectangulaire, mais de faible épaisseur. Elle doit contenir un objet, tel qu'une tranche ou plaque de silicium 1. En conséquence, la boîte comprend principalement un corps 2 à l'intérieur duquel est placé l'objet 1. Ce corps peut être en matière plastique ou en métal. Il est réalisé de préférence par un profilé dont la forme et le nervuràge peuvent assurer une bonne rigidité.

Une autre partie essentielle de la boîte est constituée de la porte 10 qui ferme le corps 2 sur une première ouverture de la première face latérale 3 du corps 2, de préférence sur toute la longueur de cette face latérale. La fermeture et l'ouverture de cette porte 10 est assurée par un dispositif de verrouillage et de déverrouillage, symbolisée sur cette figure 1 par une barre transversale de manoeuvre 11 montée pivotante autour d'un axe horizontal 12 traversant la porte au moyen de deux leviers 13.

Selon l'invention, la troisième partie principale de la boîte est un bloc aéraulique 20 placé à l'opposé de la porte 10 sur une deuxième face latérale 4 du corps 2, de préférence sur toute la longueur de cette deuxième face latérale 4. La fonction de ce bloc aéraulique 20 est de distribuer à l'intérieur du volume du corps 2 un flux d'air, de gaz ou d'atmosphère spéciale, de façon à ce que la tranche de silicium 1 soit entourée de ce flux d'air. Ce dernier peut également servir à balayer les parois internes du corps 2. A cet effet, le bloc aéraulique 20 comprend une arrivée aéraulique 21 alimentant le bloc aéraulique 20 en atmosphère spéciale. On signale que cette atmosphère spéciale peut être un gaz ultrapropre ou de l'azote.

Le bloc aéraulique 20 possède également de préférence un système d'ancrage 22 placé à l'extérieur de manière à permettre l'ancrage de la boîte à un organe de manutention adapté.

Le bloc aéraulique 20 peut également se compléter d'une carte informatique 23 placée sur la face externe 24 du bloc aéraulique 20. Cette carte informatique 23 est agencée de manière à pouvoir être activée à tout moment. On peut ainsi lire et écrire des informations sur cette carte. Ces informations concernent de préférence l'objet 1 contenu dans le corps 2 de la boîte et en particulier des informations concernant son traitement et sa fabrication et les postes de travail que cette tranche de silicium 1 a déjà traversés et ceux qu'elle doit traverser.

La boîte a été représentée sur un rayonnage 31 d'un râtelier de stockage ou de transport 30 en correspondance. Un tel râtelier 30 peut donc comporter des moyens de connexion avec la carte informatique 23.

En référence à la figure 2, une réalisation préférentielle du système de fermeture et d'ouverture de la porte 10 est réalisée sous la forme d'un dispositif du type à capsulage à levier, tel que ceux utilisés pour fermer les bouteilles de limonade. Il se compose principalement de la barre transversale 11 maintenue en dehors du corps 2 au moyen de deux leviers 13. L'ensemble est donc monté pivotant autour de l'axe horizontal 12. Une rotation de 180° de l'ensemble des deux leviers 13 et de la barre 11 permet une rotation également d'un point d'articulation 14 placé sur les leviers 13, alors que deux leviers porteurs 15 maintiennent latéralement la porte 10, en regard de la première face latérale 3 du corps 2. On constate qu'une rotation complète permet de faire passer ce point d'articulation 14 au-delà d'un point permettant de tirer au maximum la porte 10 contre le corps 2. Au-delà de cette position, la porte 10 est verrouillée contre le corps 2.

La barre transversale 11 est montée de manière à rester constamment dehors du corps 2.

Un joint 16 peut être monté sur la face interne de la porte 10 pour assurer une étanchéité complète avec le corps 2.

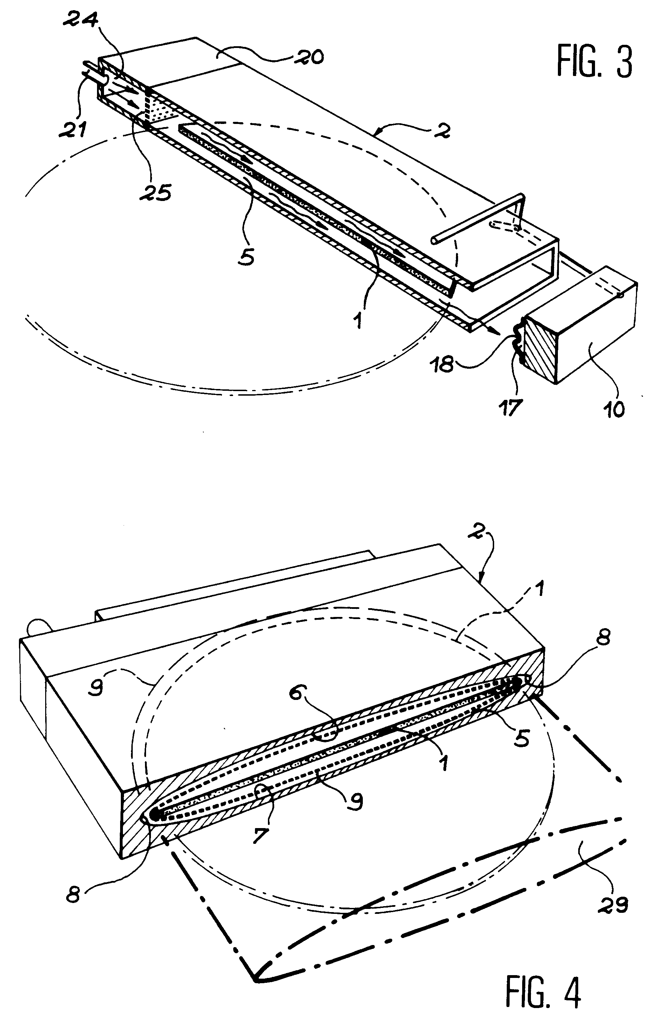

Sur la figure 3, qui permet de voir en coupe l'intérieur du corps 2 de la boîte, il est possible de distinguer sur la face interne de la porte 10 un mors interne 17 ayant une légère cavité 18 au milieu. Ce mors interne 17 permet de maintenir la tranche de silicium 1 à l'intérieur du corps 2, lors de la fermeture de la porte 10.

De l'autre côté de cette figure, on distingue le bloc aéraulique 20, ainsi que son arrivée aéraulique 21 débouchant à l'intérieur d'un volume interne 24. Un diffuseur de l'atmosphère spéciale complète le bloc aéraulique 20.

Une première réalisation du diffuseur, représentée sur cette figure 3, montre une plaque perforée 25, à la manière d'une grille. Ainsi, l'air arrivant au moyen de l'arrivée aéraulique 20 à l'intérieur du volume interne 24 du bloc aéraulique 20 est diffusé à l'intérieur du volume interne 5 du corps 2.

Un tel flux d'air propre ou d'azote peut ainsi entourer l'objet 1 contenu à l'intérieur d'une boîte, à savoir une tranche de silicium. La vitesse et le débit du gaz distribué à l'intérieur du volume 5 sont tels qu'un flux laminaire ou quasiment laminaire est obtenu à l'intérieur du volume 5 pour que la tranche de silicium 1 soit balayée de manière régulière et sans turbulence. La plaque perforée 25 peut avoir une forme permettant de bloquer l'objet 1. En effet, si cette forme est complémentaire à la forme circulaire de l'objet 1, la plaque perforée 25 peut contribuer au maintien de l'objet à l'intérieur du corps 2.

En référence à la figure 4, montrant le volume interne 5 du corps 2, une caractéristique principale de la boîte selon l'invention est que ce corps interne possède des moyens latéraux de maintien de l'objet 1. En effet, celui-ci est maintenu à l'intérieur du corps 2 sans toucher les surfaces supérieure 6 et inférieure 7 du corps 2. Ainsi, le flux d'air formé par le diffuseur 25 de la figure 3 peut entourer complètement les deux faces de la tranche de silicium 1 et assurer ainsi son balayage aéraulique.

La réalisation représentée sur la figure 4 montre que la section transversale du volume interne 5 du corps 2 peut être une ellipse dont les sommets 8 du grand axe de l'ellipse constituent chacun un rayonnage pour maintenir la tranche de silicium 1. L'espace entre cette tranche de silicium 1 et des surfaces supérieure 6 et inférieure 7 du volume interne 5 du corps 2 doit être suffisant pour que le flux puisse être quasiment laminaire et pour qu'un doigt terminal d'un robot puisse venir en dessous de la tranche de silicium 1 pour procéder à la saisie de cette dernière. Un robot du type "pick and place" convient pour ce type d'opérations et est compatible avec une telle boîte selon l'invention.

Sur cette figure 4, est suggérée, en traits interrompus, une enveloppe 9 entourant la tranche de silicium 1. Cette enveloppe 9 a une ouverture 29 correspondant à celle de la première face latérale du corps 2 et est fixée autour de celle-ci. La partie arrière de cette enveloppe 39 épouse la forme de la tranche de silicium 1.

Une telle enveloppe filtrante 9 est amovible, c'est-à-dire interchangeable. De plus, elle est semi-rigide et est élastique de manière à appliquer la tranche de silicium 1 constamment vers la porte 10. De la sorte, lors de la fermeture de la porte 10 contre le corps 2, l'enveloppe 9 a tendance à pousser la tranche de silicium 1 contre la porte 10, plus exactement dans le creux 18 du mors 17 de la porte 10. Le maintien longitudinal de la tranche de silicium 1 est ainsi assuré.

Cette enveloppe filtrante 9 permet également de diffuser le flux d'air ultrapropre ou d'azote issu du bloc aéraulique 20 autour de la tranche de silicium 1. La première réalisation du diffuseur sous la forme d'une paroi perforée 25 est alors supprimée, l'enveloppe filtrante permettant de réaliser cette fonction de diffusion homogène de l'air ultrapropre ou de l'azote autour des deux faces de la tranche de silicium 1.

On obtient ainsi une boîte étanche confinant la tranche de silicium 1 dans un environnement adapté à son traitement ou à sa fabrication.

Il est également possible de faire régner à l'intérieur de la boîte des pressions différentes, telles qu'une légère surpression pour assurer la protection pendant les transports et le stockage de la tranche de silicium 1. De même, le vide partiel peut être obtenu à l'intérieur de la boîte, si des joints d'étanchéité sont placés entre la porte 10 et le corps 2 et entre le corps 2 et le bloc aéraulique 20.

La boîte selon l'invention peut donc devenir active, c'est-à-dire que le volume interne 5 du corps 2 est balayée par le flux d'air ultrapropre grâce au bloc aéraulique 20. Ainsi, la protection de la plaque de silicium 1 contre l'atmosphère qui peut être contaminante est assuré bien que la porte 10 ouverte. De même, des parois internes du volume interne 5 du bord 2 sont protégées. On peut ainsi ouvrir la boîte pour saisir la tranche de silicium 1 et l'introduire dans un poste de travail. A cet effet, un système d'encliquetage mécanique 27 est prévu sur la paroi externe 28 de la porte 10 pour solidariser la boîte avec la porte d'un système extérieur, à savoir un poste de travail. Ainsi, la boîte peut être ouverte conjointement à l'ouverture du poste de travail et l'atmosphère de confinement de la tranche de silicium 1 insufflé par le bloc aéraulique 20 peut ainsi être le même que celui régnant à l'intérieur du poste de travail. Il en est de même lors de la réintroduction dans la boîte de la tranche de silicium 1 après son traitement dans le poste de travail.

Bien sûr, l'objet de l'invention peut s'appliquer à d'autres réalisations que celles de circuits intégrés. Elles peuvent concerner tout traitement ou toute manipulation d'objets plats en atmosphère contrôlée ou sous vide.

## Revendications

1. Boîte plate de confinement d'un objet plat (1) sous atmosphère spéciale, comportant :
- un corps (2) plat, et possédant une première ouverture sur une première face latérale (3) et des moyens internes, latéraux de maintien de l'objet (1), la boîte étant placée horizontale, l'objet (1) ne devant pas toucher les parois supérieure (6) et inférieure (7) du volume interne (5) du corps (2), et
- une porte latérale (10) devant être placée en regard de l'ouverture de la première face latérale (3) du corps (2) ;
caractérisée en ce qu'elle comprend :
- un bloc aéraulique (20) placé sur une ouverture d'une deuxième face latérale (4) du corps (2) opposée à la première face (3), pouvant être relié à un moyen d'alimentation (21) en atmosphère spéciale pour distribuer à l'intérieur du corps (2) l'atmosphère spéciale par la deuxième ouverture (4), y compris le vide ;
- un mors interne (17) fixé sur la face interne de la porte (10) pour bloquer longitudinalement l'objet (1) ;
- un système d'encliquetage (27) placé sur la face externe (28) de la porte (10) pour solidariser la porte (10) de la boîte avec une porte d'un système extérieur à l'intérieur duquel l'objet (1) contenu dans la boîte doit être introduit.

2. Boîte selon la revendication 1, caractérisée en ce que la section interne du volume interne (5) du corps (2) est une ellipse horizontale, les moyens internes latéraux de maintien de l'objet (1) étant constitués des sommets (8) du grand axe de l'ellipse.

3. Boîte selon la revendication 1, caractérisée en ce qu'elle comprend un système d'ancrage (22) fixé sur le bloc aéraulique (20) pour permettre la fixation de la boîte à un organe de manutention externe.

4. Boîte selon la revendication 1, caractérisée en ce qu'elle comprend une carte informatique (23) fixée sur la surface externe (24) du bloc aéraulique (20) et pouvant être activée pour la lecture et l'écriture d'informations véhiculées par la boîte et relative à l'objet (1) qu'elle contient.

5. Boîte selon la revendication 1, caractérisée en ce qu'elle comprend un système de fermeture et d'ouverture de la porte (10).

6. Boîte selon la revendication 5, caractérisée en ce que le système de fermeture et d'ouverture est du type à capsulage à levier, dont une barre horizontale de manoeuvre (11) dépasse du corps (2) pour permettre son actionnement.

7. Boîte selon la revendication 1, caractérisée en ce que les ouvertures (3, 4) du corps (2) s'étendent chacune sur la totalité de leur face latérale correspondante (3, 4), et en ce que le bloc aéraulique (20) possède un diffuseur placé dans toute la deuxième ouverture pour diffuser à l'intérieur du corps (2) par un écoulement quasiment laminaire un gaz constituant l'atmosphère spéciale.

8. Boîte selon la revendication 7, caractérisée en ce que le diffuseur est constitué par une paroi perforée (25).

9. Boîte selon la revendication 7, caractérisée en ce que la paroi perforée (25) a une forme choisie pour assurer le blocage de l'objet (1).

10. Boîte selon la revendication 7, caractérisée en ce que le diffuseur est réalisé sous la forme d'une enveloppe filtrante (9), amovible, interchangeable et semi-rigide entourant l'objet (1), possédant une ouverture latérale (29) pour l'introduction de l'objet (1), et permettant de diffuser l'atmosphère autour de l'objet (1).

11. Boîte selon la revendication 10, caractérisée en ce que l'enveloppe filtrante (9) est élastique et est fixée à la porte (10) pour assurer le blocage longitudinal de l'objet (1) contre la face interne de la porte (10) et l'accès à l'objet (1) par un doigt terminal d'un robot du type 〈〈 pick and place 〉〉.

## Claims

1. Flat case for containing a flat object (1) under a special atmosphere, comprising:
- a flat body (2) having a first opening on a first lateral face (3) and lateral internal means for holding the object (1), since, with the case placed horizontally, the object (1) is not to touch the upper wall (6) and lower wall (7) of the internal volume (5) of the body (2), and
-- a lateral door (10) which is to be placed opposite the opening of the first lateral face (3) of the body (2);
characterized in that it comprises:
- a ventilation unit (20) placed on an opening of a second lateral face (4) of the body (2) opposite the first face (3) and which can be connected to a means (21) for supplying a special atmosphere so as to distribute the special atmosphere, including a vacuum, into the body (2) via the second opening (4);
- an internal jaw (17) fixed on the internal face of the door (10) to immobilize the object (1) longitudinally;
- a snap-fastening system (27) placed on the external face (28) of the door (10) to secure the door (10) of the case to a door of an external system into the interior of which the object (1) contained in the case is to be introduced.

2. Case according to Claim 1, characterized in that the internal cross section of the internal volume (5) of the body (2) is a horizontal ellipse, the lateral internal means for holding the object (1) consisting of the crests (8) of the major axis of the ellipse.

3. Case according to Claim 1, characterized in that it comprises an anchoring system (22) fixed on the ventilation unit (20) to allow the case to be fixed to an external handling member.

4. Case according to Claim 1, characterized in that it comprises a computer card (23) fixed on the external surface (24) of the ventilation unit (20) and which can be activated for reading and writing information carried by the case and relating to the object (1) it contains.

5. Case according to Claim 1, characterized in that it comprises a system for closing and opening the door (10).

6. Case according to Claim 5, characterized in that the closing and opening system is of the latch lock lever type, a horizontal operating bar (11) of which protrudes from the body (2) to actuate it.

7. Case according to Claim 1, characterized in that the openings (3, 4) of the body (2) each extend over their entire corresponding lateral face (3, 4), and in that the ventilation unit (20) has a diffuser placed across the entire second opening to diffuse a gas that constitutes the special atmosphere into the body (2) with practically laminar flow.

8. Case according to Claim 7, characterized in that the diffuser consists of a perforated wall (25).

9. Case according to Claim 7, characterized in that the perforated wall (25) has a shape which is chosen to immobilize the object (1).

10. Case according to Claim 7, characterized in that the diffuser is produced in the form of a removable, interchangeable and semi-rigid filter envelope (9) surrounding the object (1), having a lateral opening (29) for introducing the object (1) and allowing the atmosphere to be diffused around the object (1).

11. Case according to Claim 10, characterized in that the filter envelope (9) is elastic and is fixed to the door (10) to longitudinally immobilize the object (1) against the internal face of the door (10) and to allow the end finger of a robot of the pick and place type access to the object (1).

## Patentansprüche

1. Flache Verschlussdose eines flachen Gegenstands (1) in einer speziellen Atmosphäre, umfassend:
- ein flaches Gehäuse (2), das auf einer ersten Seitenfläche (3) eine erste Öffnung besitzt und seitliche Inneneinrichtungen zum Festhalten des Gegenstands (1), wobei die Dose horizontal angeordnet ist und der Gegenstand (1) die obere Wand (6) und die untere Wand (7) des Innenvolumens (5) des Gehäuses (2) nicht berühren darf, und
- eine seitliche Tür (10), die der Öffnung der ersten Seitenfläche (3) des Gehäuses (2) gegenüberstehen muss, und
**dadurch gekennzeichnet**, dass sie enthält::
- einen Aeraulikblock (20), der sich auf einer Öffnung einer zweiten, der ersten Seitefläche (3) entgegengesetzten Seitenfläche (4) des Gehäuses (2) befindet und der mit einer Einrichtung (21) zur Realisierung einer speziellen Atmosphäre verbunden werden kann, um die spezielle Atmosphäre, das Vakuum mit einbezogen, durch die zweite Öffnung (4) im Innern des Gehäuses (2) zu verteilen bzw. herzustellen;
- eine Innenspannbacke (17), auf der Innenseite der Tür (10) befestigt, um den Gegenstand (1) in Längsrichtung zu blockieren;
- ein Einrastsystem (27), auf der Außenfläche (28) der Tür (10) angebracht, um die Tür (10) der Dose mit einer Tür eines äußeren Systems zu verbinden, in dessen Innern der in der Dose enthaltene Gegenstand (1) eingeführt werden soll.

2. Dose nach Anspruch 1, dadurch gekennzeichnet, dass der Innenquerschnitt des Innenvolumens (5) des Gehäuses (2) eine horizontale Ellipse ist, wobei die seitlichen Inneneinrichtungen zum Festhalten des Gegenstands (1) durch die Scheitel (8) der Hauptachse der Ellipse gebildet werden.

3. Dose nach Anspruch 1, dadurch gekennzeichnet, dass sie ein Verankerungssystem (22) umfasst, das an dem Aeraulikblock (20) befestigt ist, um die Befestigung des Gehäuses an einer externen Handhabungsvorrichtung zu ermöglichen.

4. Dose nach Anspruch 1, dadurch gekennzeichnet, dass sie eine Informatikkarte (23) umfasst, befestigt an der Außenoberfläche (24) des Aeraulikblocks (20), die für das Auslesen und Einschreiben von Informationen aktiviert werden kann, die den in der Dose enthaltenen Gegenstand (1) betreffen.

5. Dose nach Anspruch 1, dadurch gekennzeichnet, dass sie ein Schließ- und Öffungssystem der Tür (10) umfasst.

6. Dose nach Anspruch 5, dadurch gekennzeichnet, dass das Schließ- und Öffnungssystem vom Typ der Verkapselung mit Hilfe eines Hebels ist, dessen horizontale Handhabungsstange (11) aus dem Gehäuse (2) vorsteht, um seine Betätigung zu ermöglichen.

7. Dose nach Anspruch 1, dadurch gekennzeichnet, dass die Öffnungen (3, 4) des Gehäuses (2) sich jeweils über die Gesamtheit ihrer entsprechenden Seitenfläche (3, 4) erstreckt, und dass der Aeraulikblock (20) einen Diffusor besitzt, der in der gesamten zweiten Öffnung angeordnet ist , um eine quasi laminare Strömung eines die spezielle Atmosphäre bildenden Gases ins Innere des Gehäuses (2) zu blasen.

8. Dose nach Anspruch 7, dadurch gekennzeichnet, dass der Diffusor durch eine perforierte Wand (25) gebildet wird.

9. Dose nach Anspruch 7, dadurch gekennzeichnet, dass die perforierte Wand (25) eine Form hat, die so gewählt wurde, dass sie die Blockierung des Gegenstands (1) sicherstellt.

10. Dose nach Anspruch 7, dadurch gekennzeichnet, dass der Diffusor in Form einer herausnehmbaren, austauschbaren und halbsteifen, den Gegenstand umgebenden Filterhülle (9) realisiert wird, die eine seitliche Öffnung (29) zur Einführung des Gegenstands (1) hat und ermöglicht, die Atmosphäre um den Gegenstand (1) herum zu blasen.

11. Dose nach Anspruch 10, dadurch gekennzeichnet, dass diese Filterhülle (9) elastisch ist und an der Tür (10) befestigt ist, um die Blockierung des Gegenstands (1) in Längsrichtung gegen die Innenseite der Tür (10) und den Zugang zum Gegenstand (1) durch einen Endfinger eines Roboters des Typs 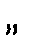 pick and place" sicherzustellen.
